# EUROPEAN PATENT SPECIFICATION

(11) **EP 2 294 244 B1**
(45) Date of publication and mention of the grant of the patent: **05.10.2016**
(21) Application number: 09754101.5
(22) Date of filing: 27.05.2009
(51) Int. Cl.: C23C 16/452, C23C 16/458, C23C 16/455

(54) **THERMAL GRADIENT ENHANCED CHEMICAL VAPOUR DEPOSITION.**
VERFAHREN ZUR TEMPERAURGRADIENTGESTÜTZTEN CHEMISCHEN GASPHASENABSCHEIDUNG.
PROCÉDÉ DE DÉPÔT DE VAPEUR CHIMIQUE À GRADIENT THERMIQUE.

(30) Priority: 28.05.2008 US 56619 P
(43) Date of publication of application: 16.03.2011
(73) Proprietor: Aixtron SE, 52134 Herzogenrath (DE)
(72) Inventor: TEO, Kenneth, Cambridge CB23 5BH (GB); RUPESINGHE, Nalin, Cambridge CB4 3NB (GB)
(74) Representative: Grundmann, Dirk
(86) International application number: PCT/GB2009/001326
(87) International publication number: WO 2009/144456

(56) References cited:
- WO-A-2008/042691
- JP-A- H04 277 627
- JP-A- 2008 001 923
- US-A1- 2001 035 124
- US-A1- 2002 132 374
- US-A1- 2004 129 224
- US-A1- 2005 000 430
- US-A1- 2006 269 690

## Description

### FIELD OF THE INVENTION

The present invention relates to a method for thermal gradient enhanced chemical vapor deposition of nanostructures.

### BACKGROUND

The generally accepted growth mechanism for nanotubes and nanowires is the diffusion of gas through a catalyst. One of the factors controlling the rate of diffusion of the gas is the thermal gradient across the catalyst or substrate (*see, e.g.,* R.T.K. Baker, "Catalytic Growth of Carbon Filaments", Carbon, v. 27, pp. 315-329 (1989); and R. S. Wagner, in Whisker Technology, A. P. Levitt Ed., p. 47 (Wiley, New York, 1970)). Hence, for the growth of nanotubes and nanowires, especially in a vertical direction above a substrate, it is important to control the thermal gradient vertically.

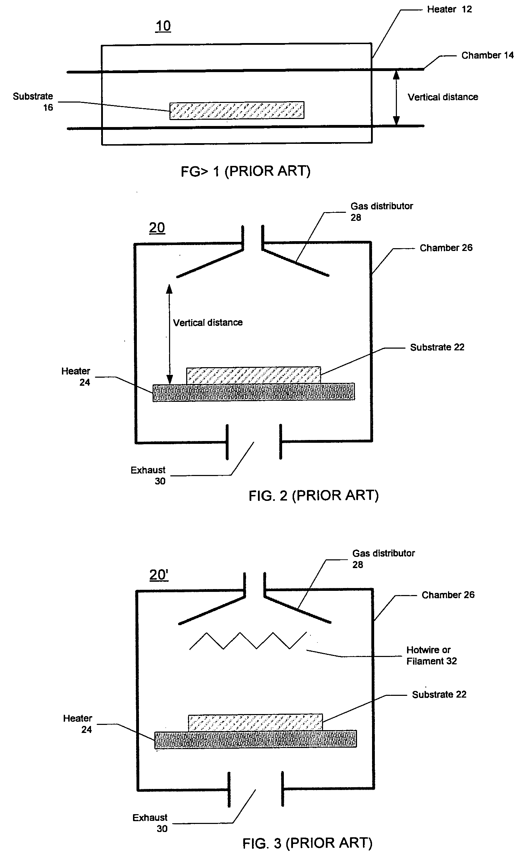

Referring to Figure 1, in a hot wall apparatus 10, a heater 12 surrounds a chamber 14 and heats the chamber, and a substrate 16 within the chamber, to a growth temperature. The gases flow horizontally through the chamber and over the substrate 16 to promote growth. The chamber and the substrate are at the same temperature and, hence, it is not possible to form a vertical temperature gradient across the wafer.

Referring to Figure 2, in a heated substrate apparatus 20, a substrate 22 is placed on a heater 24 in a chamber 26. The substrate is then heated up to the growth temperature. The gases are introduced into the chamber 26 from above (*e.g*., via gas distributor 28), which cools the top surface of the substrate, and are removed via exhaust 30. This forms a negative temperature gradient because the top side of the wafer is colder than the bottom side of the wafer, which is in contact with the heater. The negative temperature gradient can impede the growth of nanotubes and nanowires. In some cases, a plasma is used to decompose the gases above the substrate, however, the problem of the negative temperature gradient still exists.

Referring to Figure 3, in hot filament chemical vapour deposition, an apparatus 20' similar to that used in connection with the heated substrate apparatus 20 is used, except that a thin wire or filament 32 is introduced in chamber 26 between the gas distributor and the substrate 22. The thin wire or filament is used to decompose the gases before they reach the substrate. The thin wire or filament is often operated at temperatures in excess of 1000 °C. The wire is often thin and has less than 50% area coverage in order to reduce the heating effects on the substrate. The distance between the wire and the substrate is also fixed.

US2002/0132374 A1 discloses an apparatus comprising a CVD chamber, a vertically movable heated substrate support and a heated vertically movable shower head.

### SUMMARY OF THE INVENTION

In one embodiment the vapour deposition apparatus includes a chamber configured for chemical vapour deposition of a film on a substrate and which has included therein a lower heater configured to support said substrate and an upper heater disposed a vertical distance above the lower heater. The upper heater has holes therethrough to allow reaction gases to pass vertically from a gas distributor within the chamber towards the substrate. In some instances, area coverage of the upper heater is greater than 50%. Also, either or both of the upper heater and the bottom lower may be configured for vertical motion with respect to one another in order to facilitate adjustment of the vertical distance between the heaters. In some cases, the upper heater is integrated with the gas distributor.

A further embodiment of the vapour deposition apparatus includes a chamber configured for chemical vapour deposition of a film on a substrate and having included therein a lower heater configured to support said substrate and an upper heater disposed a vertical distance above the lower heater, the upper heater being positioned above a gas distributor having holes therethrough to allow reaction gases to pass vertically towards the substrate.

Still another instantiation of the vapour deposition apparatus, provides a chamber configured for chemical vapour deposition of a film on a substrate and having included therein a lower heater configured to support said substrate and an upper heater disposed a vertical distance above the lower heater, the upper heater being positioned circumferentially around a gas distributor having holes therethrough to allow reaction gases to pass vertically towards the substrate.

In any or all of the foregoing embodiments, the bottom heater may include a cooling element. Likewise, either or both of the upper and lower heaters may be configured for the application of a voltage to create a plasma.

A method consistent with an CVD apparatus involves establishing a thermal gradient between an upper heater and a lower heater within a vacuum chamber in which a substrate is positioned in the vicinity of the lower heater and introducing reaction gasses vertically into the chamber to create depositions on the substrate. The upper heater may be maintained higher or lower in temperature than the lower heater and the reaction gasses may be evacuated from the chamber using a vacuum pump after being made to flow vertically through holes in the upper heater prior to encountering a top surface of the substrate.

The present invention provides a vapour deposition method according to claim 1.

These and other features and embodiments of the present invention are described further below.

### BRIEF DESCRIPTION OF THE DRAWINGS

The present invention is illustrated by way of example, and not limitation, in the figures of the accompanying drawings, in which:
Figure 1 illustrates a conventional apparatus in which substrates are heated by way of heating elements surrounding a chamber.
Figure 2 illustrates a conventional chamber configured with a single substrate heating element.
Figure 3 illustrates a chamber configured for conventional, hot filament, chemical vapour deposition (CVD) on a substrate.
Figure 4 illustrates an apparatus employing both top and bottom heating elements in a chamber configured for growing nano-structures on substrates.
Figures 5A and 5B illustrate alternative configurations of apparatus configured for thermal gradient enhanced CVD.
Figures 6A and 6B are images taken of sample wafers, showing the growth of nanostructures.

### DETAILED DESCRIPTION

Described herein are methods and systems for thermal gradient enhanced chemical vapor deposition (TGE-CVD). In various instantiations, the present disclosure provides a CVD (or other form of deposition) chamber which includes both an upper and lower heater or heating element. The lower heater (which, during operation, may be maintained at a temperature of between 20 - 1000 °C) may be configured to support a substrate or other work piece, and the upper heater (which, during operation, may be maintained at a temperature of between 20 - 1000 °C) is disposed a certain distance (e.g., 5 - 75 mm) above the lower heater. In some instances, the upper heater may have holes running therethrough, to allow reaction gases to pass vertically from a gas distributor within the chamber towards the substrate. For example, the upper heater may be integrated with the gas distributor.

Either or both of the upper and/or lower heater(s) may be configured for vertical motion relative to one another. This facilitates adjustment of the vertical distance between the heaters. Further, the area coverage of the upper heater may be greater than 50%.

An alternative instantiation involves a CVD (or other form of deposition) chamber having included therein a lower heater configured to support a substrate and an upper heater disposed a vertical distance above the lower heater, and above a gas distributor. This arrangement allows reaction gases to pass unimpeded in a vertical direction towards the substrate.

Still another instantiation provides an apparatus that includes a CVD chamber. Included in the CVD chamber is a lower heater configured to support a substrate and an upper heater disposed a vertical distance above the lower heater, and being positioned circumferentially around a gas distributor having holes therethrough to allow reaction gases to pass vertically towards the substrate. In some instances, the lower heater may include a cooling element. Further, either or both of the upper and lower heaters may be configured for the application of a voltage to create a plasma.

Regardless of the physical instantiation, systems configured in accordance with the present disclosure are able to establish a thermal gradient between an upper heater and a lower heater within a vacuum chamber in which a substrate is positioned (usually, though not necessarily in the vicinity of the lower heater). Reaction gasses are introduced vertically into the chamber to create depositions on the substrate and the temperature gradient is preserved by maintaining one of the heaters higher in temperature than the other.

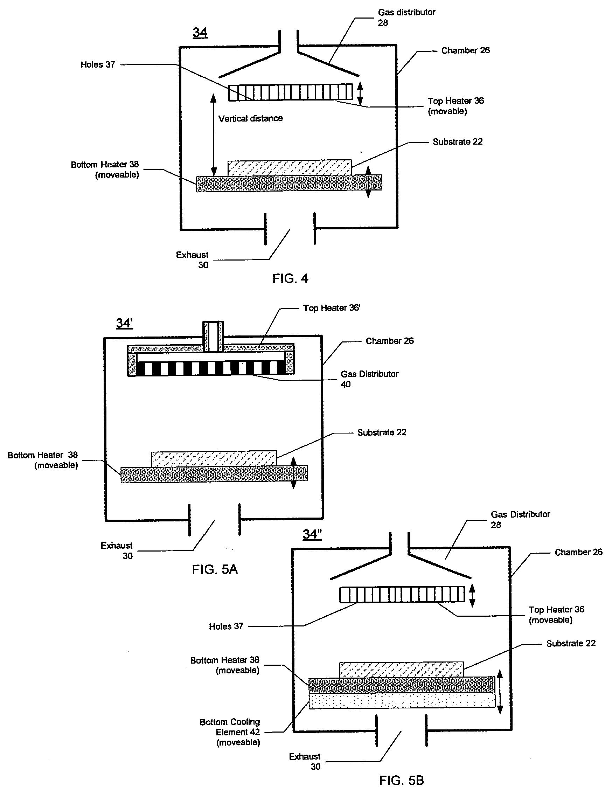

Now referring to Figure 4, an apparatus 34 configured for thermal gradient enhanced CVD in accordance with an embodiment of the present disclosure is illustrated. The substrate 22 is placed on a bottom heater 38 within chamber 26. This may be done using a conventional vacuum robotic wafer handler as is known in the art. A top heater 36, with holes 37 therethrough to allow the reaction gases to pass vertically from the gas distributor 28 to the substrate 22, is suspended above the substrate 22. The area coverage of the top heater is preferably greater than 50%, to maximise the efficiency of the top heater in creating a vertical thermal gradient within the chamber. Either or both of the top heater 36 or the bottom heater 38 may be moved vertically in order to facilitate the adjustment of the vertical distance between the heaters.

The difference in temperature between the heaters, as well as the distance between the heaters, can be used to control the thermal gradient across the vertical dimension of substrate 22. For example, if the top heater is higher in temperature than the bottom heater, a positive thermal gradient (from the top of the substrate to the bottom of the substrate) is formed. On the other hand, if the bottom heater is higher in temperature than the top heater, a negative thermal gradient (from the top of the substrate to the bottom of the substrate) is formed.

A variety of different chamber/heater configurations may be employed. For example, Figure 5A shows a configuration in which the apparatus 34' includes a top heater 36' (which may be moveable or fixed) that is integrated with a gas distributor 40. Gas distributor 40 may be configured as a showerhead, with multiple gas exit ports or injectors to provide gasses in the direction of the substrate. In this particular instance, the top heater 36' is positioned above the showerhead 40, but other embodiments may incorporate these elements in different fashions. For example, the heater element may be positioned circumferentially around the showerhead or centrally therein.

Yet a further embodiment is illustrated in Figure 5B. In this implementation, the apparatus 34" includes a bottom heater 38, which itself includes a cooling element 42. Both the bottom heater 38 and the cooling element 42 may be moveable (either collectively or independently of one another) so as to maintain a constant temperature of the substrate 22 if there is excessive radiative heating from the top heater 36 in situations where the top heater is moved into close proximity with the substrate to create a large thermal gradient. Additionally, in any of the above-described configurations, voltages can be applied to the top and/or bottom heaters to create a plasma.

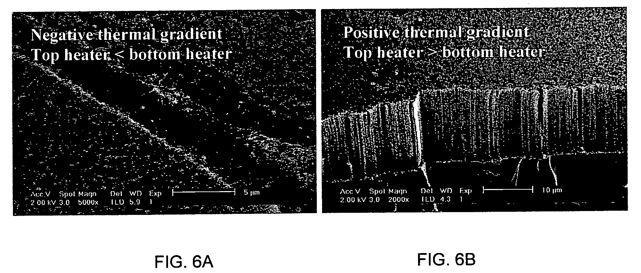

Figures 6A and 6B are images taken of sample wafers, each at 650 °C, and illustrate the growth of nano-structures in apparatus configured in accordance with embodiments of the present disclosure. In Figure 6A, the growth was conducted in a negative thermal gradient environment, in which the top heater had a temperature lower than the bottom heater. In Figure 6B, the growth was conducted in a positive thermal gradient environment, in which the top heater had a temperature greater than the bottom heater.

It should be appreciated that many details of an apparatus suitable for performing the nano-structure growth operations described herein have not been presented in detail so as not to unnecessarily obscure the features of the present disclosure. Such details would, of course, be required for an operational system, but are known in the art. For example, U.S. Patent 5,855,675, assigned to the assignee of the present invention and incorporated herein by reference, provides a good discussion of features which may included in an apparatus that also includes dual heaters in accordance with the present disclosure. In general, such a commercial apparatus may be organized as a cluster-tool-based processing system operating substantially within a vacuum chamber. A wafer transfer apparatus may be positioned to operate from the center of the vacuum chamber and be adapted to place and retrieve, by rotation and extension, substrates, typically semiconductor wafers, from and to processing chambers configured in the manner described above and appended at points around the periphery of substantially circular vacuum transfer chamber. Wafers may be moved from an outside environment into the vacuum chamber through a load-lock, then through one or more processing chambers, and finally back to the outside environment through an unload lock. Gases used in processing may be introduced via a gas feed and control unit through conduit(s) and manifolds, such as the showerhead manifold discussed above. Alternatively, other gas distributor manifolds may be used.

The processing chambers are typically maintained at atmospheric pressure or below atmospheric pressure through the use of vacuum pumps fluidly coupled to the chamber exhausts. This avoids contamination by atmospheric gases and other particles. During processing in one of the processing chambers, vacuum pumping may be throttled to control process chamber pressure without using excessive quantities of process gases. Such throttling may be accomplished in a number of ways, including by valves having controllable openings. In a typical process cycle, after processing is complete, gases are valved off and the throttling mechanism is opened to allow maximum pumping speed in the processing chamber. The purpose is to reduce the gas pressure in the processing chamber to a value close to that in the substrate transfer chamber. Then, the processed wafer may be removed from the chamber.

A drive assembly mounted below a processing chamber may be used to raise and lower an internal pedestal on which the substrate support (e.g., the bottom heater) is attached. Alternatively, the bottom heater may be included within such a pedestal. Usually though, the pedestal apparatus will have a heated hearth for supporting and providing heat to a wafer to be processed. When the pedestal is in a lowermost position wafers may be inserted into the chamber and released to lie upon the hearth, and, after the transfer apparatus withdraws, the pedestal may be raised, moving the supported wafer up into a processing position to be processed. The procedure may be reversed when the wafer is to be removed from the processing chamber. Vacuum integrity may be maintained for the overall assembly while allowing vertical freedom of motion for the pedestal by means of a bellows. It will be apparent to those of ordinary skill in the art that there are other mechanisms by which the pedestal assembly may be translated in a vertical fashion, and there are a variety of alterations that might be made without departing from the scope of the invention. There are, for example, a number of different extensible drives that might be used, such a air cylinders, air-oil systems, hydraulic systems, and the like.

Thus, means for thermal gradient enhanced chemical vapor deposition have been described. Although discussed with reference to several illustrated embodiments, the present invention is not intended to be limited by the examples provided in these illustrations. For example, the methods and system of the present disclosure may also be used for controlled growth of thin films via diffusion through intermediate films, either top down or bottom parallel to the direction of the thermal gradient.

## Claims

1. A method for chemical vapour deposition of a film on a substrate with an apparatus, comprising: a chamber configured for chemical vapour deposition of said film on a substrate and having included therein a lower heater configured to support said substrate and an upper heater disposed a vertical distance above the lower heater,
the upper heater is integrated with a gas distributor and having holes therethrough to allow reaction gases to pass vertically from the gas distributor within the chamber towards the substrate or being positioned above a gas distributor having holes therethrough to allow reaction gases to pass vertically towards the substrate or
being positioned circumferentially around a gas distributor having holes therethrough to allow reaction gases to pass vertically towards the substrate,
wherein both of the upper heater and the bottom heater are configured for vertical motion with respect to one another in order to facilitate adjustment of the vertical distance between the heaters
wherein the substrate is positioned in the vicinity of a lower heater and introducing the reaction gases vertically into the chamber to create depositions on the substrate,
wherein a thermal gradient across the vertical dimension of said substrate is controlled by a difference in temperature between the heaters and the distance between the heaters

2. The method of claim 1, wherein the bottom heater includes a cooling element.

3. The method of claim 1 or claim 2, wherein either or both of the upper and lower heaters is configured for the application of a voltage to create a plasma.

4. The method of any one of the preceding claims, wherein the upper heater is maintained higher in temperature than the lower heater.

5. The method of any one of the preceding claims, wherein the lower heater is maintained higher in temperature than the upper heater.

6. The method of any one of the preceding claims, further comprising evacuating the reaction gases from the chamber using a vacuum pump.

## Patentansprüche

1. Ein Verfahren zur chemischen Gasphasenabscheidung einer Schicht auf einem Substrat mit einer Vorrichtung aufweisend eine für eine chemische Gasphasenabscheidung einer Schicht auf einem Substrat ausgebildete Kammer und einen von dieser beinhalteten unteren Heizer zum Tragen des Substrates und einem vertikal mit Abstand oberhalb des unteren Heizers angeordneten oberen Heizer,
wobei der obere Heizer Bestandteil eines Gasverteilers ist und Durchtrittsöffnungen zum vertikalen Durchtritt eines Reaktionsgases aus dem Gasverteiler in die Kammer in Richtung des Substrates aufweist, oder
oberhalb eines Gasverteilers mit Durchtrittsöffnungen zum vertikalen Durchtritts eines Reaktionsgases in Richtung des Substrates angeordnet ist, oder
um einen Gasverteiler mit Durchtrittsöffnungen zum vertikalen Durchtritt eines Reaktionsgases in Richtung des Substrates herum angeordnet ist,
wobei beide, der obere Heizer und der untere Heizer, in der Lage sind, vertikal relativ zueinander bewegt zu werden, um den vertikalen Abstand zwischen den Heizern einstellen zu können,
wobei das Substrat in der Nähe des unteren Heizers angeordnet ist und wobei Reaktionsgase vertikal in die Kammer eingespeist werden, zum Erreichen einer Abscheidung auf dem Substrat,
wobei ein vertikaler Temperaturgradient durch das Substrat durch einen Unterschied zwischen den Temperaturen zwischen den Heizern und dem Abstand zwischen den Heizern eingestellt wird.

2. Verfahren nach Anspruch 1, wobei der untere Heizer ein Kühlelement aufweist.

3. Verfahren nach Anspruch 1 oder nach Anspruch 2, wobei an einem oder beiden des oberen und des unteren Heizers eine Spannung anlegbar ist, um eine Plasma zu erzeugen.

4. Verfahren nach einem der vorhergehenden Ansprüche, wobei der obere Heizer auf einer höheren Temperatur gehalten wird, als der untere Heizer.

5. Verfahren nach einem der vorhergehenden Ansprüche, wobei der untere Heizer auf einer höheren Temperatur gehalten wird, als der obere Heizer.

6. Verfahren nach einem der vorhergehenden Ansprüche, wobei ferner die Reaktionsgase mittels einer Vakuumpumpe aus der Kammer entfernt werden.

## Revendications

1. Un procédé de dépôt chimique en phase vapeur d'un film sur un substrat avec un appareil, comprenant : une chambre configurée pour le dépôt chimique en phase vapeur de ce film sur un substrat et incluant en son intérieur un élément chauffant inférieur configuré pour supporter ledit substrat et un élément chauffant supérieur disposé à une distance verticale au-dessus de l'élément chauffant inférieur,
l'élément chauffant supérieur est intégré avec un distributeur de gaz et ayant des trous le traversant qui permettent à des gaz réactifs de passer verticalement du distributeur de gaz à l'intérieur de la chambre vers le substrat ou
étant positionné au-dessus d'un distributeur de gaz ayant des trous le traversant pour permettre à des gaz réactifs de passer verticalement vers le substrat ou
étant positionné circonférentiellement autour d'un distributeur de gaz ayant des trous le traversant pour permettre à des gaz réactifs de passer verticalement vers le substrat,
dans lequel l'élément chauffant supérieur et l'élément chauffant inférieur sont configurés tous les deux pour se déplacer verticalement l'un par rapport à l'autre de manière à faciliter l'ajustement de la distance verticale entre les éléments chauffants
dans lequel le substrat est positionné au voisinage d'un élément chauffant inférieur et on introduit les gaz réactifs verticalement dans la chambre pour créer des dépôts sur la substrat,
dans lequel un gradient thermique à travers la dimension verticale dudit substrat est contrôlé par une différence de température entre les éléments chauffants et la distance entre les éléments chauffants.

2. Le procédé de la revendication 1, dans lequel l'élément chauffant inférieur inclut un élément de refroidissement.

3. Le procédé de la revendication 1 ou de la revendication 2, dans lequel l'un des deux ou les deux éléments chauffants supérieur et inférieur sont configurés pour l'application d'une tension pour créer un plasma.

4. Le procédé selon l'une quelconque des revendications précédentes, dans lequel l'élément chauffant supérieur est maintenu à une température supérieur à celle de l'élément chauffant inférieur.

5. Le procédé selon l'une quelconque des revendications précédentes, dans lequel l'élément chauffant inférieur est maintenu à une température supérieur à celle de l'élément chauffant supérieur.

6. Le procédé selon l'une quelconque des revendications précédentes, comprenant en outre le fait d'évacuer les gaz réactifs de la chambre en utilisant une pompe à vide.
